# FASCICULE DE BREVET EUROPEEN

(11) **EP 1 366 827 B1**
(45) Date de publication et mention de la délivrance du brevet: **06.09.2006**
(21) Numéro de dépôt: 03354047.7
(22) Date de dépôt: 28.05.2003
(51) Int. Cl.: B05D 1/18, C30B 33/00

(54) **L'utilisation d'un substrat adapté pour la fabrication de monocouches moléculaires organisées et structures ainsi obtenues**
Die Verwendung eines angepassten Substrat für die Herstellung von organisierten molekularen Monoschichten und damit hergestellte Strukturen
The use of a substrate adapted for the fabrication of organised molecular monolayers and structures thus obtained

(30) Priorité: 28.05.2002 FR 0206526
(43) Date de publication de la demande: 03.12.2003
(73) Titulaire: European Synchrotron Radiation Facility, 38043 Grenoble Cedex (FR); CENTRE NATIONAL DE LA RECHERCHE SCIENTIFIQUE (CNRS), 75794 Paris Cedex 16 (FR); COMMISSARIAT A L'ENERGIE ATOMIQUE, 75752 Paris Cédex 15 (FR)
(72) Inventeur: Struth, Bernd, 38600 Fontaine (FR); Rieutord, Francois, 38120 Saint-Egreve (FR); Terech, Pierre, 38500 Saint-Cassien (FR)
(74) Mandataire: de Beaumont, Michel

(56) Documents cités:
- EP-A- 1 132 739
- US-A- 5 545 432
- US-A- 5 738 720
- MARQUES C ET AL: "Annealing behaviour of natural topaz implanted with W and Cr ions" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, vol. 166-167, mai 2000 (2000-05), pages 204-208, XP004204073 ISSN: 0168-583X
- PAXTON T E ET AL: "Mineral substrates as heterogeneous nucleants in the crystallization of proteins" JOURNAL OF CRYSTAL GROWTH, NORTH-HOLLAND PUBLISHING CO. AMSTERDAM, NL, vol. 198-199, mars 1999 (1999-03), pages 656-660, XP004170935 ISSN: 0022-0248

## Description

La présente invention concerne la réalisation de monocouches organiques, organométalliques ou inorganiques greffées sur un substrat, présentant une organisation moléculaire régulière sur une surface notable.

Depuis quelques années, on cherche à déposer des monocouches (ou des empilements de monocouches) de molécules simples ou complexes sur des substrats. Diverses applications de telles monocouches ont déjà été décrites dans la technique, comme capteurs, semiconducteurs, guides d'onde, etc.

Toutefois, jusqu'à présent on s'est heurté à un obstacle fondamental qui est que l'on n'arrive pas à former des monocouches parfaitement ordonnées ou monocristallines sur de relativement grandes surfaces. Les meilleurs substrats proposés actuellement pour déposer de telles monocouches sont des métaux tels que l'or, sur lesquels se fixent par exemple des molécules d'alcanéthiol. Toutefois, en pratique, on n'arrive pas à obtenir des monocouches parfaitement ordonnées sans joints de grain sur des distances supérieures à environ 30 nm (des surfaces supérieures à environ 1000 nm²). On a également essayé d'accrocher des molécules à des substrats de silicium. Néanmoins, dans cette technique, la présence d'une couche très mince d'oxyde amorphe ne permet pas d'imposer l'ordre cristallin du substrat de silicium à la couche organique.

Ainsi, un objet de la présente invention est, selon la revendication 1, l'utilisation d'un nouveau type de substrat permettant un greffage simple, et ordonné sur une surface importante, de molécules organiques, organométalliques ou inorganiques en monocouche.

Un autre objet de la présente invention concerne la structure obtenue par ce greffage selon la revendication 2

Pour atteindre cet objet, la présente invention prévoit d'utiliser des substrats minéraux monocristallins dont la formule chimique comprend des groupements hydroxyles (OH) et dont un plan de clivage, plan sur une surface notable, comprend des groupements hydroxyles accessibles en surface. Parmi ces substrats, on choisira des cristaux dont les paramètres de maille, et plus particulièrement la distance entre groupements hydroxyles, sont compatibles avec l'encombrement des molécules à greffer.

Les molécules à greffer seront par exemple des chaînes aliphatiques telles que des chaînes alcanes ou des composés aromatiques tels que des composés benzéniques. Ces molécules présentent une extrémité carbonée diméthyl chlorée.

Plus particulièrement, la présente invention propose d'utiliser des substrats monocristallins choisis dans le groupe comprenant la topaze (Al₂SiO₄(F,OH)₂) et le diaspore (AlOOH).

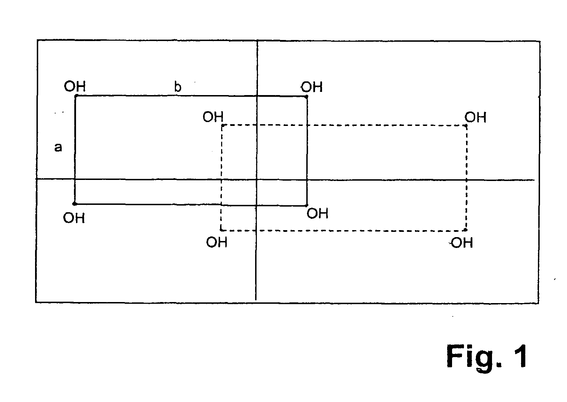

Dans un exemple de réalisation préféré, le substrat est un cristal de topaze. Les demandeurs ont montré que si on clive un cristal de topaze selon le plan (001), on obtient en surface des groupements hydroxyles répartis de façon régulière sans aucun défaut cristallin après le clivage. La figure 1 représente la maille de la topaze dans le plan (001). Les paramètres de maille a, b et c sont a=0,465 nm, b=0,879 nm, et c=0,839 nm. L'espacement entre les groupements hydroxyles OH est de 0,465 nm selon l'axe a et de 0,44 nm selon l'axe b. La surface occupée par chaque groupement hydroxyle OH est de 0,2044 nm², et permet le greffage ordonné de chaînes moléculaires.

Des chloroalkylsilanes tels que le diméthyloctadécylchlorosilane, C₂₀H₄₃ClSi, ou le diméthyldécylchlorosilane, C₁₂H₂₇ClSi sont adaptés pour le greffage. Le triméthylchloroétain, C₃H₉ClSn, autorise également la réaction de greffage et permet ainsi, après réaction, de disposer d'une couche organométallique R-Sn-O-, semiconductrice en surface. On pourra aussi accrocher des chlorures simples tels que le chlorure d'étain CISn pour obtenir une monocouche d'étain. Dans ces divers cas, l'accrochage se fait par réaction entre le chlore et le groupement hydroxyle OH et élimination de chlorure d'hydrogène HCl.

Hormis l'extrémité halogénée, le reste de la molécule pourra être fonctionnalisé selon les applications désirées. La molécule comportera un élément lui conférant une propriété fonctionnelle souhaitée ou lui permettant de se lier à une molécule conférant cette propriété fonctionnelle souhaitée. Des groupements insaturés (aromatiques, hétérocycles), des groupements ioniques ou des groupements organométalliques pourront être utilisés. On pourra choisir tout composé ou groupement propre à conférer des propriétés particulières à la surface exposée. Par exemple, on pourra accrocher des groupements présentant une ionicité positive ou négative, pour constituer un détecteur de polarité. On pourra également accrocher des groupements propres à conférer à la surface exposée un caractère hydrophile ou hydrophobe

L'accrochage ou assemblage des molécules sur le substrat peut se faire en mettant en contact pendant 60 minutes la topaze correctement clivée, et une solution des molécules à greffer (le diméthyloctadécylchlorosilane, par exemple) dans le tétrahydrofurane (THF) parfaitement anhydre. Le substrat est ensuite rincé au THF anhydre sous argon et conservé dans un dessicateur sous vide. Le demandeur a ainsi réalisé des surfaces de topaze de 1 cm² recouvertes de chaînes alcanes octadécyl (C₁₈) avec un ordre bidimensionnel monocristallin sur l'ensemble de la surface du substrat.

La présente invention est susceptible de diverses variantes et modifications qui apparaîtront à l'homme de l'art.

Comme la topaze, le diaspore satisfait aux critères de l'invention (cristal clivable dont un plan de clivage comprend des groupements hydroxyles accessibles en surface, la distance entre groupements hydroxyles dans le plan de clivage étant compatible avec l'encombrement des molécules à greffer). Toutefois, de nombreux minéraux clivables et contenant des groupements OH ne sont pas satisfaisants. Ainsi, la muscovite, le talc, la pyrofullite sont des minéraux clivables mais dont les groupements OH ne sont pas accessibles. L'amblygonite possède bien des groupements OH mais le minéral n'est pas clivable. La prussite est un minéral clivable et qui possède des groupements OH dans ce plan de clivage mais espacés à des distances trop petites pour permettre à la réaction chimique de greffage d'avoir lieu.

De façon générale, la présente invention vise un substrat adapté au greffage chimique d'une monocouche moléculaire ordonnée, constitué d'un cristal dont la formule comprend un groupement hydroxyle, ce cristal étant clivable de façon que des groupements hydroxyles apparaissent dans le plan de clivage, et appartenant au groupe comprenant la topaze et le diaspore.

La présente invention vise aussi une structure comportant un substrat tel que susmentionné auquel on a greffé des molécules comportant une extrémité diméthyl chlorée, hydrocarbonée ou métallique.

Selon un mode de réalisation de la présente invention, les molécules greffées comportent une chaîne aliphatique.

Selon un mode de réalisation de la présente invention, les molécules greffées comportent une chaîne perfluorée.

Selon un mode de réalisation de la présente invention, les molécules greffées comportent une chaîne insaturée.

Selon un mode de réalisation de la présente invention, les molécules greffées comportent une chaîne aromatique.

Selon un mode de réalisation de la présente invention, les molécules greffées comportent une chaîne organométallique.

Selon un mode de réalisation de la présente invention, les molécules greffées comportent un groupement hétérocyclique.

Selon un mode de réalisation de la présente invention, on a fixé aux molécules greffées des groupements fonctionnels désirés.

Selon un mode de réalisation de la présente invention, on a fixé au substrat à température ambiante des chaînes de diméthyloctadécylchlorosilane en solution dans du tétrahydrofurane.

## Revendications

1. Utilisation pour le greffage chimique d'une monocouche moléculaire ordonnée d'un substrat cristallin appartenant au groupe comprenant la topaze et le diaspore dont la formule comprend un groupement hydroxyle, ce cristal étant clivé de façon que des groupements hydroxyles apparaissent dans le plan de clivage.

2. Structure comprenant un substrat cristallin appartenant au groupe comprenant la topaze et le diaspore clivé de façon que des groupements hydroxyles apparaissent dans le plan de clivage, sur lequel est greffée une monocouche moléculaire ordonnée.

3. Structure selon la revendication 2, dans laquelle les molécules greffées comportent une extrémité diméthyl chlorée, hydrocarbonée ou métallique.

4. Structure selon la revendication 3, dans laquelle les molécules greffées comportent une chaîne aliphatique.

5. Structure selon la revendication 3, dans laquelle les molécules greffées comportent une chaîne perfluorée.

6. Structure selon la revendication 3, dans laquelle les molécules greffées comportent une chaîne insaturée.

7. Structure selon la revendication 6, dans laquelle les molécules greffées comportent une chaîne aromatique.

8. Structure selon la revendication 3, dans laquelle les molécules greffées comportent une chaîne organométallique.

9. Structure selon l'une quelconque des revendications 3 à 6, dans laquelle les molécules greffées comportent un groupement hétérocyclique.

10. Structure selon la revendication 3, dans laquelle on a fixé aux molécules greffées des groupements fonctionnels désirés.

11. Structure selon la revendication 1, dans laquelle on a fixé à température ambiante sur le substrat des chaînes de diméthyloctadécylchlorosilane en solution dans du tétrahydro-furane.

## Claims

1. Use for the chemical grafting of an ordered molecular monolayer of a crystalline substrate, belonging to the group comprising topaz and diaspore, the lattice of which comprises a hydroxyl group, this crystal being cleaved so that hydroxyl groups appear in the cleavage plane.

2. A structure comprising a crystalline substrate belonging to the group comprising topaz and diaspore cleaved so that hydroxyl groups appear in the cleavage plane, on which an ordered molecular monolayer is grafted.

3. The structure of claim 2, in which the grafted molecules comprise a chlorinated, hydrocarbonated, or metallic dimethyl end.

4. The structure of claim 3, wherein the grafted molecules comprise an aliphatic chain.

5. The structure of claim 3, wherein the grafted molecules comprise a perfluorinated chain.

6. The structure of claim 3, wherein the grafted molecules comprise an unsaturate chain.

7. The structure of claim 6, wherein the grafted molecules comprise an aromatic chain.

8. The structure of claim 3, wherein the grafted molecules comprise an organometallic chain.

9. The structure of any of claims 3 to 6, wherein the grafted molecules comprise a heterocyclic group.

10. The structure of claim 3, wherein desired functional groups have been fixed on the grafted molecules.

11. The structure of claim 2, on which have been fixed at room temperature chains of dimethyloctadecyl-chlorosilane in solution in tetrahydrofurane.

## Patentansprüche

1. Verwendung zur chemischen Pfropfung einer geordneten molekularen Monoschicht eines kristallinen Substrats, zugehörig zu der Gruppe, umfassend Topas und Diaspor, dessen Gitter eine Hydroxylgruppe umfaßt, wobei dieser Kristall so gespalten ist, daß Hydroxylgruppen in der Spaltebene auftreten.

2. Struktur, umfassend ein kristallines Substrat, zugehörig zu der Gruppe, umfassend Topas und Diaspor, das so gespalten ist, daß Hydroxylgruppen in der Spaltebene auftreten, auf der eine geordnete molekulare Monoschicht aufgepfropft ist.

3. Struktur nach Anspruch 2, bei der die aufgepfropften Moleküle ein mit Chlor, Kohlenwasserstoff oder metallischem Dimethyl versehenes Ende uznfassen.

4. Struktur nach Anspruch 3, wobei die aufgepfropften Moleküle eine aliphatische Kette umfassen.

5. Struktur nach Anspruch 3, wobei die aufgepfropften Moleküle eine perfluoliette Kette umfassen.

6. Struktur nach Anspruch 3, wobei die aufgepfropften Moleküle eine ungesättigte Kette umfassen.

7. Struktur nach Anspruch 6, wobei die aufgepfropften Moleküle eine aromatische Kette umfassen.

8. Struktur nach Anspruch 3, wobei die aufgepfropften Moleküle eine organometallische Kette umfassen.

9. Struktur nach einem der Ansprüche 3-6, wobei die aufgepfropften Moleküle eine heterozyklische Gruppe umfassen.

10. Struktur nach Anspruch 3, wobei erwünschte funktionelle Gruppen auf den aufgepfropften Molekülen befestigt sind.

11. Struktur nach Anspruch 2, auf der bei Zimmertemperatur Ketten von Dimcthyloctadecylchlarsilan in Lösung in Tetrahydrofuran fixiert worden sind.
